Europäisches Patentamt

European Patent Office

Office européen des brevets

Publication number: **0 275 686**

**A1**

# EUROPEAN PATENT APPLICATION

Application number: 87311237.9

Int. Cl.⁴ **H05K 3/46**

Date of filing: 21.12.87

Priority: **19.12.86 GB 8630392**

Date of publication of application:
**27.07.88 Bulletin 88/30**

Designated Contracting States:
**AT BE CH DE ES FR GB GR IT LI LU NL SE**

Applicant: **Prestwick Circuits Limited**
**Mosshill Industrial Estate**
**Ayr Scotland(GB)**

Inventor: **Laing, Jed**
**80 Rowan Crescent**
**Ayr Scotland(GB)**

Representative: **Murgitroyd, Ian G. et al**
**Murgitroyd and Company Mitchell House 333**
**Bath Street**
**Glasgow G2 4ER(GB)**

(54) **Improved multi-layer printed circuit boards, and methods of manufacturing such boards.**

(57) A layer of copper foil (14, 16) is etched to a required conductor pattern, coated with a thin layer of uncured fibre-free epoxy polymer, (26, 28) and then another layer of copper foil (22, 24) is placed on top. The sandwich is bonded by heat and pressure which cures the layer of polymer (26, 28). The top foil (22, 24) is etched to form another required conductor pattern which is both electrically insulated from and mechanically adhered to the underlying conductor layer (14, 16) by the layer (26, 28) of cured polymer. These steps are repeated as often as is necessary to build up the required number of layers. Interconnections between different layers are either formed by drilling and plating through holes (30), or by a etching hole in a conductor (222) and then plasma etching through the exposed polymer (226) to the underlying conductor (214) with subsequent metal plating (235) to join the conductors in the different layers. The outermost conductive layer can be formed as physically isolated pads or islands of metal. Connections to and from these pads are through conductors buried in the underlying layer of the polymer.

FIG. 3

EP 0 275 686 A1

## "Improved Multi-Layer Printed Circuit Boards, and Methods of Manufacturing Such Boards"

This invention relates to improved multi-layer printed circuit boards, and to methods of manufacturing such boards.

## BACKGROUND OF THE INVENTION

The ever-increasing complexity and component density of electronic circuits consisting of integrated circuits and/or discrete components mounted on printed circuit boards (PCB's) requires multilayer PCB's consisting of two or more layers of conductors which are interconnected from layer to layer at selected points. PCB's commonly consist of a substrate layer for mechanical strength, the substrate layer being of electrically insulating material. One layer of copper foil can readily be attached to either face of such substrates, etched to form selected patterns of conductor tracks, drilled where interconnections are to be formed, and the holes through-plated to complete the electrical interconnections between the two conductor layers. However, difficulties arise in forming two or more layers of condutors on one face (or on each of both faces) of a substrate, since the substrate is no longer available to serve as the necessary layer of electrical insulation between the conductor layers. In such cases it is conventional to place a glass-fibre cloth impregnated with polymer between the conductive layers as the necessary electrical insulation. Such conventional insulating layers are relatively thick, slow to cure, and contain glass which can fragment to contaminate copper surfaces in certain parts of the manufacturing process. Such conventional insulating layers also have poor ability to encapsulate high aspect ratio features in the underlying conductor layer, such as narrow conductors formed in thick copper.

A further problem arises in forming an outermost conductor layer having only pads of relatively small area to form test points and connections for attachment of surface mounted devices (legless integrated circuits with edge rows of very closely spaced connections) since these pads require to be solder coated. The solder is liable to form unwanted bridges between adjacent pads and between pads and adjacent conductor tracks that are not intended to be connected to the pads. Encapsulation of inter-pad areas to prevent solder bridging is complex or impracticable with conventional PCB manufacturing techniques.

## OBJECTS OF THE INVENTION

It is an object of the invention to provide a multilayer printed circuit board which obviates or mitigates the above-described disadvantages. It is another object of the invention to provide a method of manufacturing such a multilayer printed circuit board which obviates or mitigates the disadvantages of conventional manufacturing methods.

## SUMMARY OF THE INVENTION

According to the first aspect of the invention there is provided a multi-layer printed circuit board comprising a planar substrate having two opposed major faces, at least two superimposed electrically conductive layers on at least one major face of the substrate. each said conductive layer being formed into a predetermined pattern of electrical conductors, each said conductive layer being electrically insulated from the next adjacent conductive layer on the same major face of the substrate by an interposed layer of an electrically insulating polymer other than at predetermined locations where conductive layers are intentionally interconnected by inter-layer electrical interconnections, said polymer also functioning as an adhesive to cause mutual adherence of adjacent conductive layers whereby said multi-layer printed circuit board is a mechanically coherent structure.

Each said conductive layer is preferably a copper foil. The conductive layer or layers adjacent the substrate may be adhered to the respective face of the substrate by a further layer of the same polymer material. The polymer is preferably devoid of non-polymeric materials, such as glass and or fibrous materials. Each interposed layer of polymer preferably extends between adjacent electrical conductors in the conductive layer which the polymer layer overlies to fill inter-conductor spaces with electrically insulating polymer and to encapsulate said conductors.

The outermost conductive layer on the or each side of the substrate may have its respective predetermined pattern of electrical conductors in the form of a plurality of mutually physically isolated islands or pads of which selected ones are electrically interconnected to at least one conductor in at least one underlying conductive layer whereby only said pads are externally exposed on that face of the board and such of said pads as are electrically interconnected to at least one conductor extending to at least one other location on the board are so connected by conductors which are encapsulated within the structure of the board. Thus conductors exposed to soldering operation(s) are minimised in number and areas and are physically separated so far as possible, these factors resulting in minimal risk of solder bridging which causes short-circuit faults. (Some pads may optionally remain without electrical interconnections to serve purely as mechanical mountings for components soldered or otherwise attached to them).

According to a second aspect of the invention, there is provided a method of manufacturing a multi-layer printed circuit board comprising the steps of:-

(a) providing a planar substrate having two opposed major faces and which is coated on at least one of said major faces with an electrically conductive layer;

(b) forming the at least one electrically conductive layer into a predetermined pattern of electrical conductors;

(c) coating the pattern of electrical conductors formed by the preceding steps with a layer of an electrically insulating polymer;

(d) overlaying the layer of electrically insulating polymer formed by the preceding step with a further electrically conductive layer and adhering said further layer to the underlying electrically conductive layer by means of the interposed layer of electrically insulating polymer;

(e) forming the further electrically conductive layer added by the preceding step into a predetermined pattern of electrical conductors;

(f) repeating steps (c), (d) and (e) a predetermined number of times, said predetermined number being in the range from zero upwards, until a required plurality of layers of conductors is formed; and

(g) interconnecting selected conductors in different ones of said layers by inter-layer electrical interconnections at predetermined locations.

The foregoing steps may be carried out so as to form a plurality of layers of conductors on both major faces of the substrate, and thus provide a double-sided multi-layer PCB.

The inter-layer electrical interconnections may be formed by drilling or otherwise forming holes through the completed assembly of layers at the predetermined locations, and lining the bore of the hole from end to end with conductive material, preferably by plating with metal in one or more stages. Alternatively, the inter-layer electrical interconnections may be formed by etching or otherwise forming a hole, aperture, or gap in the selected conductor or conductors at the predetermined locations, to expose the underlying layer of polymer, forming a corresponding hole, aperture, or gap in the underlying layer of polymer by plasma etching until said layer is penetrated to expose an underlying conductor, and conductively joining said two conductors, preferably by lining the hole, aperture or gaps in the polymer by means of a metal plating process. These steps of alternately etching holes in conductors and plasma etching holes in the polymer can be repeated as often as is required to interconnect as many layers as is required at any one location. In contrast to conventional through-board drilling, the plasma etching process can form inter-layer interconnections of limited depth which only partially penetrate the PCB. An inter-layer interconnection can be made prior to the addition of further alternate layers of polymer and conductor, such that the interconnection is "buried" in the finished PCB and not exposed at the surface of the finished PCB. Further, the plasma etching process can be adapted in this way to forming more than one inter-layer interconnection at a given location on the PCB, but with these interconnections being electrically separated from each other by being formed at different depths in the finished PCB (this being in total contrast to the limitations of conventional drilled and plated through-hole interconnections).

## BRIEF DESCRIPTION OF THE DRAWINGS:-

Embodiments of the invention will now be described by way of example with reference to the accompanying drawings wherein:-

Fig.1 is a schematic part-section of a four-layer printed circuit board in accordance with the present invention;

Fig. 2 is a schematic part-section of a two-layer printed circuit board in accordance with the invention, showing an inter-layer interconnection formed by a process including plasma etching; and

Fig. 3 is a schematic part-section of a three-layer printed circuit board in accordance with the invention, showing how the process involved in Fig. 2 can be extended to forming "buried" interconnections, and interconnections between more than two adjacent conductive layers.

## DESCRIPTION OF THE PREFERRED EMBODIMENTS

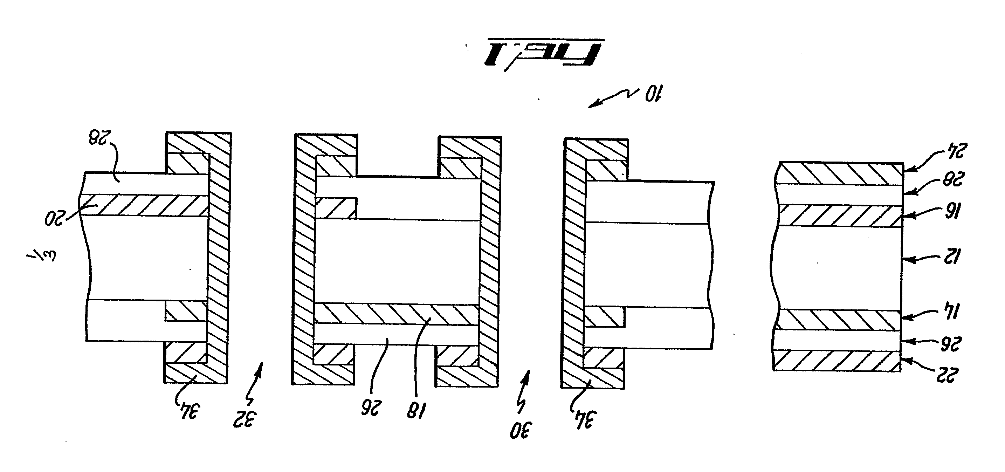

Figs 1, 2 and 3 are each schematic sectional diagrams of multi-layer laminated structures in which both absolute thicknesses and relative thicknesses are exaggerated and out of scale for the sake of clarity in demonstrating production principles and product possibilities. Also, in each of Figs 1, 2 and 3 the extreme left broken away portion of laminated structure is that of a multi-layer PCB in which no etching or other removal of material has taken place (i.e. each illustrated layer in this portion is shown as deposited), whereas the remainder of each figure shows the results of etching, hole forming, or other partial removal of deposited material to form a functioning PCB.

Referring now to Fig 1 in particular, this figure shows details of a four-layer double sided PCB 10 based on a substrate 12. The substrate 12 is a rigid sheet of glass fibre impregnated with epoxy resin, and at the start of manufacture of the board 10, both major faces of the substrate 12 are coated with a continuous layer of copper. The upper face of the substrate 12 has a copper foil layer 14 and the lower face of the substrate 12 has a copper foil layer 16. Desired patterns of conductors are formed in each of the copper foil layers 14 and 6 by the following process:-

(A) The outer surface of each foil layer 14 and 16 is coated with a photosensitive etch resist;

(B) Each coating of resist is exposed to suitable light through a respective photogaphic stencil so as to illuminate and harden the resist in a pattern overlying the areas where copper conductors are to be formed (the stencils being mutually aligned to register the respective patterns on both sides of the PCB);

(C) The resist is developed to dissolve the unexposed resist and thus leave the foil covered with tracks or areas of hardened etch resist where conductors are to be formed, while exposing the remainder of the copper foil;

(D) The exposed copper is etched away to form the desired patterns of conductors 18 and 20 in the formerly continuous copper foils 14 and 16; and

(E) The hardened resist (defining the conductor patterns 18 and 20) is removed to leave only copper on each face of the substrate 12.

The result of the process steps A-E is an inner layer for the eventual PCB 10. This inner layer may optionally be coated with an adhesion promoter, such as black or red copper oxide (cupric oxide or cuprous oxide).

This resultant inner layer is then coated on both sides with a thin layer of uncured polymer. The uncured polymer layers each have a thickness of about 10-200 micrometres. The polymer is preferably an epoxy polymer or a modified epoxy-based polymer.

A sheet of copper foil, respectively 22 and 24, is placed on each side of the inner layer, and the resultant assembly is subjected to combination of heat and pressure to cure the polymer and thus cause the foils 22 and 24 to be adhered to the respective underlying conductors 18 and 20 by respective cured polymer layers 26 and 28. These cured polymer layers 26 and 28 also serve to provide electrical insulation between the foils 22 and 24 and the respective underlying conductors 18 and 20. It will be noted that the cured polymer layers 26 and 28 also enter the spaces etched away from the original foil layers 14 and 16 to define the lateral gaps between the conductor patterns 18 and 20 and so totally encapsulate these conductors.

As an alternative to the above-described steps, the foils 22 and 24 may each be thinly coated on one side with uncured polymer, and then applied to the inner layer (formed as described above), followed by thermal and pressure bonding as before to form the same coherent laminated structure.

As the next step, at predetermined locations where interlayer electrical interconnections are to be formed (and or mechanical fasteners are to be inserted) holes 30 and 32 are drilled completely through the laminated structure. The bores of the holes 30 and 32 are coated with copper using an electroless copper plating bath.

The following steps result in predetermined patterns of conductors being formed in the outer foils 22 and 24:-

(F) The outer faces of the foils 22 and 24 are coated with a photosensitive plating resist;

(G) The coatings of plating resist are illuminated with suitable light through mutually aligned photographic stencils to expose and harden the plating resist in all areas except those where conductors are to be eventually formed in the foils 22 and 24. (The outer conductor patterns may be a "pads-only" array of mutually isolated copper islands forming mounting points and test points as previously described);

(H) The resist is developed to remove the unilluminated areas of resist (i.e. the areas of eventual conductors);

(I) The portions of the foils 22 and 24 uncovered by removal of unilluminated plating resist are electroplated with a relatively thick metal coating 34: this coating thickness is preferably about 5-50 micrometres, and the metal is preferably copper, tin lead, nickel, gold, or a mixture or alloy of two or more of these metals or metal combinations;

(J) Remaining plating resist is removed; and

(K) Unplated regions of the copper foils 22 and 24 are etched away, using the metal coatings 34 as an etch resist.

The product of the above procedures is the four-layer double-sided printed circuit board 10 of Fig. 1, which is now ready for testing and the subsequent mounting and soldering of components (not shown).

The above-described procedures can be adapted to produce printed circuit boards having more than four conductive layers by forming two or more "inner layers" as described above, and bonding them together by a conventional multilayer bonding technique. (Such a bonding technique can consist of interleaving the inner layers with a woven fabric of glass fibre impregnated with epoxy resin, and bonding the layers with a combination of heat and pressure). The resultant composite inner layer can then be treated in the same way as the simple two-layer "inner layer" of Fig. 1 and a multi-layer PCB completed by subsequently treating the composite inner layer by the same remaining steps of the procedure described with reference to Fig. 1. .

The procedures described with reference to Fig. 1 can be adapted in another way which also produces printed circuit boards having more than four conductive layers, as follows:-

After completing step (E), instead of immediately proceeding to step (F) and then the subsequent steps, steps (A)-(E) inclusive are repeated as often as is necessary to build up the required number of layers, after which steps (F)-(K) inclusive are carried out as before.

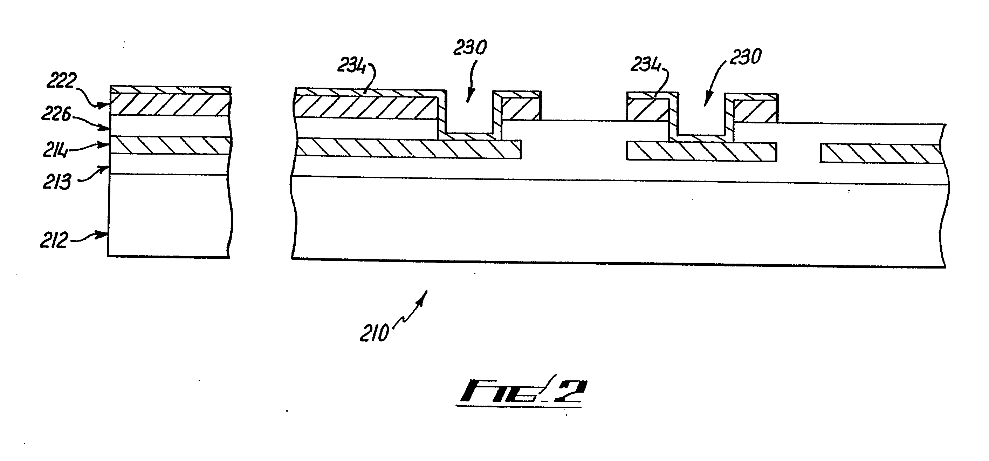

A modified form of multi-layer printed circuit board and a modified procedure for manufacturing this PCB will now be described with reference to Fig. 2. The PCB schematically shown in Fig. 2 (to the same convention as in Fig. 1) is, for simplicty, shown as two-layer single-sided PCB 210.

Referring to Fig. 2 in detail, a substrate 212 consists of a sheet of conventional epoxy-impregnated glass fibre, or of aluminium (for improved heat distribution and dissipation). The upper surface of the substrate 212 is given a thin coating of an uncured polymer. As with the Fig. 1 PCB, the Fig. 2 polymer is preferably an expoy polymer or a modified epoxy-based polymer, the coating preferably having a thickness of about 10-200 micrometres.

A sheet 214 of copper foil is applied to the coating of uncured polymer, and the sandwich is bonded by a combination of heat and pressure. The result is that the foil 214 is adhered to the substrate 212 by an intervening layer 213 of cured polymer, which also electrically insulates the foil 214 from the substrate 212. (The polymer could alternatively be coated to the foil 214 before sandwiching and bonding, as described in Fig. 1).

The foil 214 then has a pattern of conductors formed in it by the steps (A)-(E) inclusive of Fig. 1. Next, a further layer 226 of the same polymer is applied on top of the patterned foil 214, followed by a further copper foil 222 which is then provided with a pattern of conductors, in a repetition of steps (A)-(E) inclusive.

The Fig. 2 procedure now differs from the Fig. 1 procedure in that at the predetermined locations where inter-layer electrical interconnections are to be formed, holes 230 will have been etched in the outer foil 222. The polymer layer 226 underlying these holes 230 is etched through to the underlying conductive layer 214 by exposing the laminated assembly to a plasma or ionised gas. The plasma etches holes through the polymer at a relatively rapid rate. but etches the copper relatively slowly.

When the required continuations of the holes 230 are etched through the polymer layer 226 to the underlying conductive layer 214, electrical connections are made by electroless plating 234. which is optionally coated over with a thicker metal layer by means of electroplating.

The procedures described with reference to Fig. 2 could readily be duplicated to provide a double-sided printed circuit board with plasma-etched interconnection holes on each side; interconnections between opposite sides of the substrate can be made by the conventional plated through-holes shown and described in Fig. 1. One advantage of such a double-sided version of the PCB of Fig. 2 in comparison to that of Fig 1 is that inter-layer interconnnections between layers on one side only of the substrate can be located independently of those on the other side of the substrate. since the substrate is not penetrated by plasma etching. Thus greater design flexibility is provided.

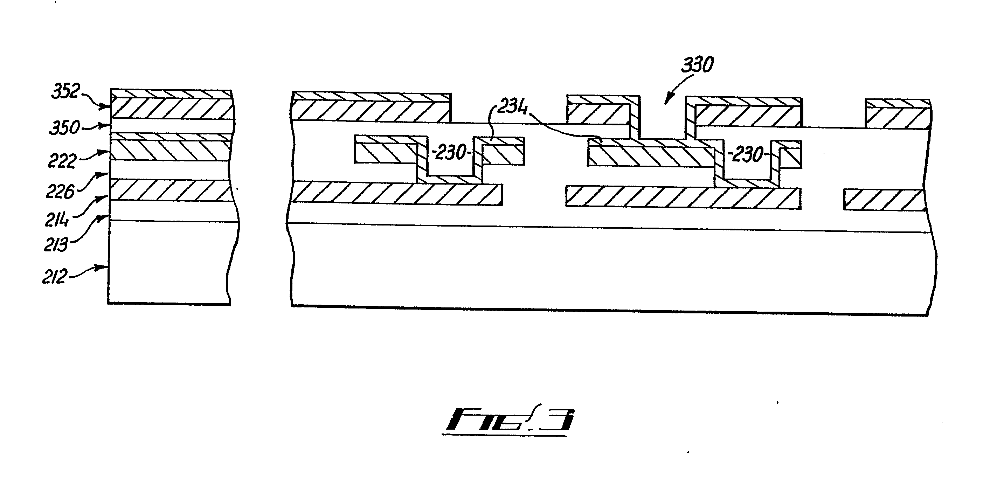

Fig. 3 shows an extension of the plasma-etched PCB of Fig. 2 to three (or more) conductive layers on one (or both) major faces of the substrate. Those parts of Fig. 3 which correspond to parts of Fig. 2 are given the same reference numerals as in Fig. 2.

Fig. 3 shows how a third (and subsequent) conductive layers can be built up on top of the basic structure of Fig. 2 by adding successive layers of polymer 350 and copper foil 352. followed by conductor patterning, plasma etching, and plating as described in Fig. 2. to form equivalent further interconnections 330. It will immediately be seen that the interconnection holes 230 of Fig 2 are effectively "buried" by the overlying polymer layer 350, and how conductors and interconnections in different layers can overlap in a manner not possible with the through-hole interconnection system of Fig. 1.

As well as extending beyond the three layers shown in Fig. 3, the Fig. 3 arrangement can equally well be made double-sided to give all the advantages of double-sided PCB's over single-sided PCB's, as well as the above-described advantages of the invention in comparison to prior art PCB's and their manufacturing methods. As well as the above-mentioned absence of glass from the inter-layer insulation, these insulating layers are much thinner than is conventional. which allows the plasma etching to form holes, and allows much faster polymer curing times, with appropriate (and frequently cheaper) polymers becoming available for choice by the PCB manufacturer using the present invention. Manufacture is also speeded up by plasma etching, since all holes are plasma etched simultaneously (in contrast to the necessity of sequentially drilling numerous holes). Also, plasma etching allows holes of any shape or size to be made, whereas conventional drilling allows only round holes above a minimum practicable diameter to be formed. The positioning of plasma etched holes is determined by the photographic stencil positioning accuracy, rather than the less reliable positioning accuracy of a drilling machine.

Plasma etching avoids the smearing with polymer of the bore of a drilled through hole, and cracking of the bore plating. All these factors contribute to economical and reliable production of PCB's with a higher component density and smaller dimensions than is feasible in conventional PCB's.

In instances where surface mounted devices are to be attached to a 'pads-only' outer conductor layer, the underlying conductive layer or layers can be etched out in the area bounded by these pads to assist the formation of a recess in the surface of the finished PCB which will help to seat the surface mounted device and accurately locate it prior to being soldered to the pads.

In addition to the alternatives described above, modifications and variations are possible within the scope of the appended claims.

## Claims

1. A multi-layer printed circuit board comprising a planar substrate having two opposed major faces, at least two superimposed electrically conductive layers on at least one major face of the substrate, each said conductive layer being formed into a predetermined pattern of electrical conductors, each said conductive layer being electrically insulated from the next adjacent conductive layer on the same major face of the substrate by an interposed layer of an electrically insulating polymer other than at predetermined locations where conductive layers are intentionally interconnected by inter-layer electrical interconnections, said polymer also functioning as an adhesive to cause mutual adherence of adjacent conductive layers whereby said multi-layer printed circuit board is a mechanically coherent structure.

2. A printed circuit board as claimed in Claim 1, wherein the conductive layer or layers adjacent the substrate are adhered to the respective face of the substrate by a further layer of the same polymer material.

3. A printed circuit board as claimed in Claim 1 wherein the polymer is devoid of non-polymeric materials.

4. A printed circuit board as claimed in Claim 1 wherein each interposed layer of polymer extends between adjacent electrical conductors in the conductive layer which the polymer layer overlies to fill inter-conductor spaces with electrically insulating polymer and to encapsulate said conductors.

5. A printed circuit board as claimed in Claim 1 wherein the outermost conductive layer on the or each side of the substrate has its respective predetermined pattern of electrical conductors in the form of a plurality of mutually physically isolated islands or pads of which selected ones are electrically interconnected to at least one conductor in at least one underlying conductive layer whereby only said pads are externally exposed on that face of the board and such of said pads as are electrically interconnected to at least one conductor extending to at least one other location on the board are so connected by conductors which are encapsulated within the structure of the board.

6. A method of manufacturing a multi-layer printed circuit board comprising the steps of:-

(a) providing a planar substrate having two opposed major faces and which is coated on at least one of said major faces with an electrically conductive layer;

(b) forming the at least one electrically conductive layer into a predetermined pattern of electrical conductors;

(c) coating the pattern of electrical conductors formed by the preceding steps with a layer of an electrically insulating polymer;

(d) overlaying the layer of electrically insulating polymer formed by the preceding step with a further electrically conductive layer and adhering said further layer to the underlying electrically conductive layer by means of the interposed layer of electrically insulating polymer;

(e) forming the further electrically conductive layer added by the preceding step into a predetermined pattern of electrical conductors;

(f) repeating steps (c), (d) and (e) a predetermined number of times, said predetermined number being in the range from zero upwards, until a required plurality of layers of conductors is formed; and

(g) interconnecting selected conductors in different ones of said layers by inter-layer electrical interconnections at predetermined locations.

7. A method as claimed in Claim 6 wherein steps (a)-(g) inclusive are duplicated so as to form a plurality of layers of conductors on both major faces of the substrate, and thus provide a double-sided multi-layer PCB.

8. A method as claimed in Claim 6 wherein the inter-layer electrical interconnections are formed by drilling or otherwise forming holes through the completed assembly of layers at the predetermined locations, and lining the bore of the hole from end to end with conductive material.

9. A method as claimed in Claim 6 wherein the inter-layer electrical interconnections are formed by etching or otherwise forming a hole, aperture, or gap in the selected conductor or conductors at the predetermined locations, to expose the underlying layer of polymer, forming a corresponding hole, aperture, or gap in the underlying layer of polymer by plasma etching until said layer is penetrated to expose an underlying conductor, and conductively joining the two said conductors.

10. A method as claimed in Claim 6 wherein at least one inter-layer interconnection is made prior to the addition of further alternate layers of polymer and conductor, such that the interconnection is buried in the finished PCB and not exposed at the surface of the finished PCB.

FIG. 1

222
226
214
213
212

234
230
234
230

210

**FIG 2**

352

350

222

226

214

213

212

330

234

-230-

-230-

0 275 686

FIG. 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | GB-A-2 030 781 (STANDARD TELEPHONES & CABLES LTD) * Page 1, line 54 - page 2, line 65 * | 1,3,4,6 -8 | H 05 K  3/46 |
| A | NEC RESEARCH & DEVELOPMENT, no. 53, April 1979, pages 30-35; H. KOBUNA et al.: "High density multilayer printed wiring board" * Page 31, figure 1 * | 5 | |
| A | EP-A-0 144 944 (E.I. DU PONT DE NEMOURS & CO.) * Claim 7 * | 9 | |
| A | FR-A-2 041 471 (COMPAGNIE INTERNATIONALE POUR L'INFORMATIQUE) * Figure 1 * | 9,10 | |
| P,X | EP-A-0 213 805 (INTERCONNECT TECHNOLOGY INC.) * Column 3, line 22 - column 6, line 51; figures * | 1,3,4,6 -10 | |

TECHNICAL FIELDS SEARCHED (Int. Cl.4)

H 05 K

The present search report has been drawn up for all claims

| Place of search | Date of completion of the search | Examiner |
|---|---|---|
| THE HAGUE | 28-03-1988 | SCHUERMANS N.F.G. |